# EUROPEAN PATENT APPLICATION

(11) **EP 4 618 136 A1**
(43) Date of publication of application: **17.09.2025**
(21) Application number: 23888383.9
(22) Date of filing: 29.09.2023
(51) Int. Cl.: H01L 21/301, H01L 21/304, H01L 21/683, H01L 25/065, H01L 25/07, H01L 25/18

(54) **METHOD FOR PRODUCING MULTILAYER DEVICE**

(30) Priority: 11.11.2022 JP 2022180788
(71) Applicant: Tazmo Co., Ltd., Okayama-shi, Okayama 701-1221 (JP)
(72) Inventor: YAMABE, Hiroshi, Okayama-shi, Okayama 701-1221 (JP); SANO, Ichiro, Okayama-shi, Okayama 701-1221 (JP)
(74) Representative: Knöner, Gregor
(86) International application number: PCT/JP2023/035598
(87) International publication number: WO 2024/101030

(57) **Abstract**

A method of manufacturing a multilayer device performs a first forming step, a second forming step, and a joining step. In the first forming step, a cutting site is formed at a first joining target provided with a plurality of chip regions while the first joining target is held by a first holding sheet. The cutting site is used for singulating the chip regions of the first joining target individually. In the second forming step, a cutting site is formed at a second joining target provided with a plurality of chip regions while the second joining target is held by a second holding sheet. The cutting site is used for singulating the chip regions of the second joining target individually. In the joining step, the first joining target and the second joining target are joined in such a manner that the respective chip regions of the first joining target and the second joining target are stacked on each other in a predetermined positional relationship therebetween by moving the first holding sheet and the second holding sheet relative to each other.

## Description

### Technical Field

The present invention relates to a technique of manufacturing a multilayer device including a plurality of stacked chips.

### Background Art

In the field of semiconductor technology, various methods such as COW (Chip on Wafer) method and WOW (Wafer on Wafer) method have been suggested as techniques of stacking chips such as LSI(large scale integration) chips three-dimensionally.

According to the COW method (see Patent Literatures 1 and 3, for example), cutting is first performed on a semiconductor wafer to divide the semiconductor wafer into a plurality of individual chips. Next, these chips are stacked one by one on a base wafer. After the chips are stacked to an intended number of stacked layers, cutting is performed on the base wafer to divide the base wafer into a plurality of individual bases (each of which is a part to become a foundation of a multilayer device). As a result, the multilayer device in which the chips are stacked on each other on the base is completed.

According to the WOW method (see Patent Literatures 2 and 3, for example), semiconductor wafers are first stacked on a base wafer. After the semiconductor wafers are stacked to an intended number of stacked layers, cutting is performed on a stack of the wafers to divide the wafer stack into a plurality of individual multilayer devices.

### Citation List

### Patent Literatures

Patent literature 1: Japanese published patent No. 5853754
Patent literature 2: Japanese published patent No. 6391999
Patent literature 3: Japanese published patent No. 6485897

### Summary of Invention

### Technical Problem

However, each of the conventional COW method and the WOW method has a problem of complicating manufacturing processes as described below.

Considering a case where a base wafer is provided with N regions (base regions) each of which is a region to become a base of a multilayer device, it is required to stack chips one by one on the N base regions according to the COW method. This requires stacking operation to be performed N times in stacking chips as a first layer on the base wafer. If chips are to be stacked to an M-th layer on the base wafer, stacking operation is required to be performed N × M times.

If thinned semiconductor wafers are required to be stacked on a base wafer according to the WOW method, it makes handling for the semiconductor wafers technically difficult to try to stack their wafers on the base wafer after thinning them. In response to this, what has conventionally been done is to join (stack) a semiconductor wafer before thinning onto the base wafer and then thin the semiconductor wafer by polishing. Meanwhile, shear stress occurs at a joint surface between wafers during polishing. Hence, if joining strength is low, the joining (stacking) between the wafers is exposed to a risk of break. This has necessitated implementation of a thermal process on a stack as a whole in order to enhance the joining strength before polishing. Hence, to stack thinned semiconductor wafers to an intended number of stacked layers on the base wafer, the thermal process for enhancing the joining strength has been required to be performed before polishing in response to each stacking of the semiconductor wafer in one layer.

Thus, regarding a technique of manufacturing a multilayer device including a plurality of stacked chips, the present invention is intended to simplify a manufacturing process remarkably.

### Solution to Problem

A method of manufacturing a multilayer device according to the present invention performs a first forming step, a second forming step, and a joining step. In the first forming step, a cutting site is formed at a first joining target provided with a plurality of chip regions while the first joining target is held by a first holding sheet. The cutting site is used for singulating the chip regions of the first joining target individually. In the second forming step, a cutting site is formed at a second joining target provided with a plurality of chip regions while the second joining target is held by a second holding sheet. The cutting site is used for singulating the chip regions of the second joining target individually. In the joining step, the first joining target and the second joining target are joined in such a manner that the respective chip regions of the first joining target and the second joining target are stacked on each other in a predetermined positional relationship therebetween by moving the first holding sheet and the second holding sheet relative to each other.

According to the above-described manufacturing method, it is possible for all the chip regions provided at the second joining target to be collectively joined to (stacked on) all the chip regions provided at the first joining target through one joining. Thus, compared to a case where the chip regions singulated individually from the second joining target are stacked one by one on the first joining target, it is possible to simplify the processes of manufacturing the multilayer device remarkably. More specifically, if the N chip regions are provided at each of the first joining target and the second joining target and if the chip regions singulated individually from the second joining target are stacked one by one on the N chip regions at the first joining target, stacking operation is required to be performed N times. On the other hand, as only one joining is required in the above-described manufacturing method, it is possible to simplify the processes of manufacturing the multilayer device remarkably.

### Advantageous Effects of Invention

According to the present invention, regarding a technique of manufacturing a multilayer device including a plurality of stacked chips, a manufacturing process is simplified remarkably.

### Brief Description of Drawings

FIG. 1 is a perspective view conceptually showing a multilayer device obtained by a manufacturing method according to an embodiment.
FIG. 2 is a plan view showing an example about chip regions provided at a chip parent material (joining target) by means of alternate long and short dashed lines.
FIG. 3 is a conceptual view showing a first forming step.
FIG. 4 is an enlarged perspective view about a part corresponding to a region Ya shown in an upper left view of FIG. 3.
FIGS. 5A and 5B are conceptual views each showing a vertical section taken along a line Za-Za shown in a lower left view of FIG. 3 and enlarged in a thickness direction. FIG. 5A shows a case where grooves are formed as cutting sites. FIG. 5B shows a case where voids are formed as the cutting sites.
FIG. 6 is a conceptual view showing a second forming step.
FIG. 7 is an enlarged perspective view about a part corresponding to a region Yb shown in an upper left view of FIG. 6.
FIG. 8A is a conceptual view showing a joining step, and FIG. 8B is a conceptual view showing a vertical section taken along a line Zb-Zb shown in FIG. 8A and enlarged in a thickness direction.
FIG. 9A is a conceptual view showing the joining step performed during repetition, and FIG. 9B is a conceptual view showing a vertical section taken along a line Zc-Zc shown in FIG. 9A and enlarged in a thickness direction.
FIG. 10 is a conceptual view showing a transferring step.
FIG. 11 is a conceptual view showing an expanding step.
FIG. 12 is a conceptual view showing a second process.
FIG. 13 is a conceptual view showing an example about a stack of chip parent materials obtained by a joining step performed first time according to a second modification by means of a vertical section thereof enlarged in a thickness direction.

### Description of Embodiments

[1] Embodiment

### [1-1] Configuration of Multilayer Device

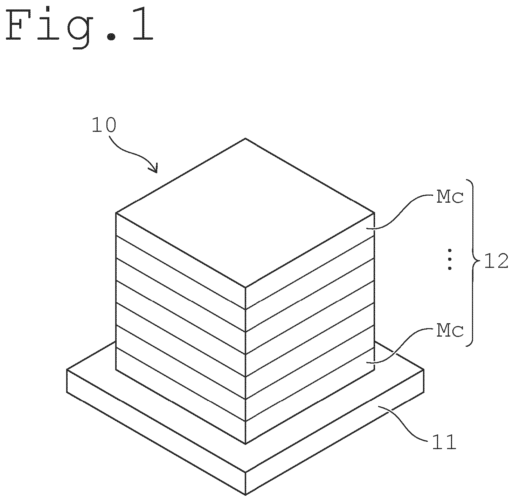

FIG. 1 is a perspective view conceptually showing a multilayer device 10 obtained by a manufacturing method according to an embodiment. As shown in FIG. 1, the multilayer device 1 includes a base 11 and a chip stack 12. Here, the base 11 is a part to become a foundation of the multilayer device 10. The base 11 is provided with an external terminal, an interconnect line, and others. The chip stack 12 is a part composed of a plurality of chips Mc stacked three-dimensionally on the base 11. In the exemplary case shown in FIG. 1, the chips Mc are stacked three-dimensionally from a first layer to a seventh layer on the base 11. While not particularly limited, the chips Mc are semiconductor chips such as LSI chips, for example.

The base 11 may be provided with a circuit same as or different from the chips Mc as well as a terminal or an interconnect line. The chips Mc forming the chip stack 12 may include those having the same circuit or those having different circuits.

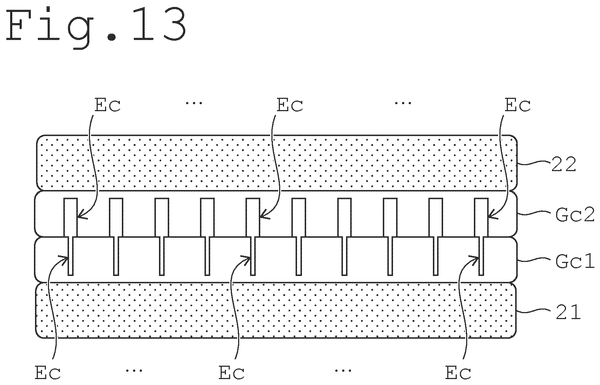

In the present embodiment, all the chips Mc have the same shape that is a rectangular shape (including a square shape) and have the same size. The base 11 has a rectangular shape (including a square shape) and has a larger size than the chips Mc. The shapes and sizes are not limited to these but may be changed, as appropriate. The shapes of the base 11 and the chips Mc may be changed to a circular shape, for example. Like in a second modification (see FIG. 13) described later, the chips Mc of different sizes may be stacked on each other on the base 11.

### [1-2] Method of Manufacturing Multilayer Device

According to the manufacturing method of the present embodiment, a first process of manufacturing the chip stack 12 of the multilayer device 10 and a second process of completing the multilayer device 10 using the chip stack 12 manufactured by the first process are performed as manufacturing processes. These processes can be realized using various types of well-known devices. The manufacturing method described below is further applicable to a case of manufacturing the multilayer device 10 including the chips Mc that are stacked on the base 11 to the number of stacked layers (two or more) not limited to seven layers (see FIG. 1).

### [1-2-1]First Process

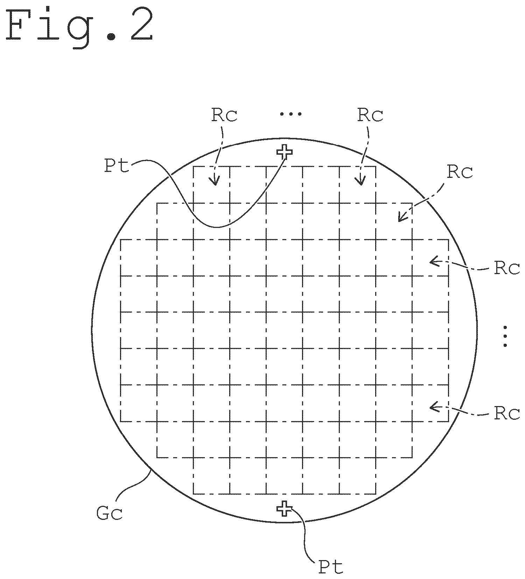

In the first process, using two or more chip parent materials Gc (see FIG. 2) each provided with a plurality of regions (chip regions Rc) to become the chips Mc, the chip parent materials Gc are joined to (stacked on) each other, thereby manufacturing the chip stack 12. FIG. 2 is a plan view showing an example about the chip regions Rc provided at the chip parent material Gc by means of alternate long and short dashed lines. While not particularly limited, the chip parent material Gc is a semiconductor wafer, for example.

In the present embodiment, in order to allow the respective chip regions Rc to be stacked on each other in a predetermined positional relationship therebetween during joining between the chip parent materials Gc, these chip parent materials Gc are each given positioning marks Pt for determining their positions relative to each other. Here, the predetermined positional relationship is a positional relationship for causing respective circuits of the chip regions Rc to be stacked to function normally in the multilayer device 10 (a positional relationship taking a position of connection between the circuits, and others, into consideration).

In the present embodiment, a thinning step, a first forming step, a second forming step, a joining step, a transferring step, and an expanding step are performed in the first process. Each of the steps will be described below in detail. In the following, two chip parent materials Mc to be joined to each other during first-time joining (stacking) will be called a "first joining target Gc1" and a "second joining target Gc2."

### <Thinning Step>

In the thinning step, the first joining target Gc1 and the second joining target Gc2 are thinned by being subjected to polishing. As an example, the first joining target Gc1 and the second joining target Gc2 are thinned to a thickness of equal to or less than 150 µm. In the present embodiment, the first joining target Gc1 is thinned before the first forming step described later. The second joining target Gc2 is thinned before the second forming step described later.

Here, if at least one of the first joining target Gc1 and the second joining target Gc2 is intended to be thinned after joining (stacking) like in the conventional case, shear stress occurs at a joint surface therebetween during polishing. As a result, if joining strength is low, the stacking is exposed to a risk of break. Hence, in order to realize thinning by the conventional method, it is necessary to enhance the joining strength by performing a thermal process on a stack as a whole before polishing. If three or more chip parent materials Gc are to be joined to (stacked on) each other, joining (stacking) is required to be performed twice or more and the thermal process for enhancing the joining strength is required to be performed before polishing in response to each joining. On the other hand, performing the above-described thinning step before joining (stacking) like in the present embodiment eliminates the need for performing the thermal process in response to each joining, thereby simplifying the manufacturing processes.

### <First Forming Step>

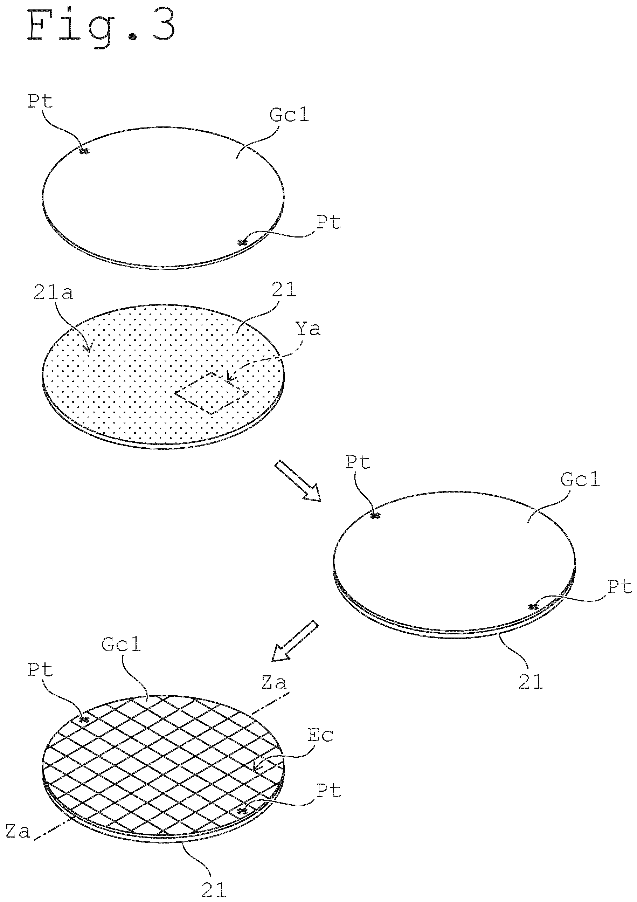

FIG. 3 is a conceptual view showing the first forming step. In the first forming step, the first joining target Gc1 thinned by the thinning step is held by a first holding sheet 21 (upper left view and right view of FIG. 3). Here, the first holding sheet 21 is a sheet containing resin (such as polyolefin or silicone) or rubber (such as fluoride rubber) having at least an attractive force as a main component thereof, and can hold the first joining target Gc1 using the attractive force of the main component. In the present embodiment, the first holding sheet 21 further has a configuration as follows.

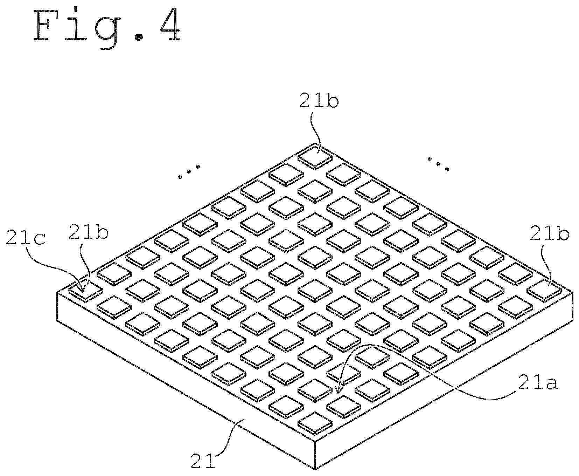

FIG. 4 is an enlarged perspective view about a part corresponding to a region Ya of the first holding sheet 21 shown in the upper left view of FIG. 3. As shown in this drawing, the first holding sheet 21 is provided with a plurality of projections 21b formed on a holding surface 21a for holding the first joining target Gc1. The projections 21b are made of a component same as the main component forming the first holding sheet 21 and are formed integrally with the first holding sheet 21. By bringing the first joining target Gc1 into surface-contact with the projections 21b, the first joining target Gc1 is held by the first holding sheet 21 using attractive forces of the projections 21b.

Meanwhile, when the first joining target Gc1 is held on the holding surface 21a, the first joining target Gc1 comes into surface-contact with the holding surface 21a only in parts where the projections 21b are provided. In the example of FIG. 4, the projections 21b are each formed in such a manner that a contact surface 21c thereof to come into contact with the first joining target Gc1 has a rectangular shape (including a square shape). As long as the contact surface 21c of the projection 21b allows the first joining target Gc1 to be held thereon, the shape thereof is not limited to a rectangular shape but may be changed to various shapes including a polygonal shape and a circular shape, as appropriate.

According to the first holding sheet 21 described above, it is possible to adjust an area of contact with the first joining target Gc1 by setting the number of the projections 21b or the area of the contact surface 21c. This eventually makes it possible to adjust the force of the first holding sheet 21 for holding the first joining target Gc1 (namely, a total sum of the attractive forces of the projections 21b). By adjusting the holding force of the first holding sheet 21, it becomes possible to maintain the holding force required for the first process and peel the first holding sheet 21 easily from the first joining target Gc1 after the first joining target Gc1 and the second joining target Gc2 are joined to (stacked on) each other in the joining step described later. More specifically, it is possible to adjust the holding force of the first holding sheet 21 at an appropriate degree so as not to break a joint part during peeling of the first holding sheet 21 from the first joining target Gc1. As a result, by holding the first joining target Gc1 using the described first holding sheet 21, it becomes possible to hold the first joining target Gc1 firmly and facilitate peeling or transfer without causing adverse effect (such as break) on the joint part and others when the peeling or transfer becomes necessary. Thus, even the thinned first joining target Gc1 can still be handled easily.

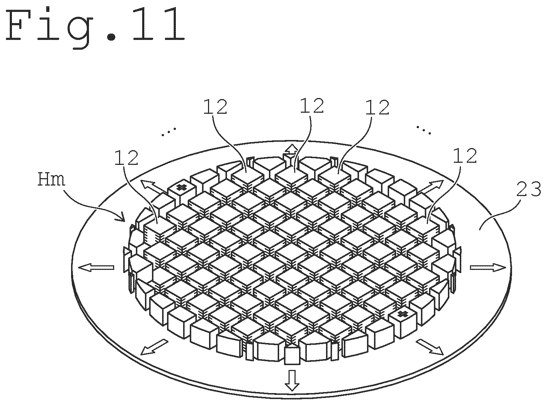

In the first forming step, after holding of the first joining target Gc1 using the first holding sheet 21, cutting sites Ec to be used for singulating the chip regions Rc of the first joining target Gc1 individually are formed at the first joining target Gc1 in the holding state (lower left view of FIG. 3). In the present embodiment, at least any one of a groove, a hole, and an internal defect is formed as the cutting site Ec to cause the first joining target Gc1 to fracture when an expandable and contractible sheet 23 is expanded in the expanding step (see FIG. 11) described later. Here, if a target (the first joining target Gc1 in this case) is planned to fracture along a predetermined line (this predetermined line will hereinafter be called a "fracture planned line"), the groove is a groove with a closed bottom formed along the fracture planned line, and the hole is a plurality of through holes formed in a plurality of sites at the position of the fracture planned line. Furthermore, the internal defect is a defect such as a void, a crack, or a modifying layer formed at the position of the fracture planned line and inside the target using laser light. Such an internal defect can be formed by bringing the laser light to a focus inside the target. A technique of causing the target to fracture using the internal defect is a technique called stealth dicing.

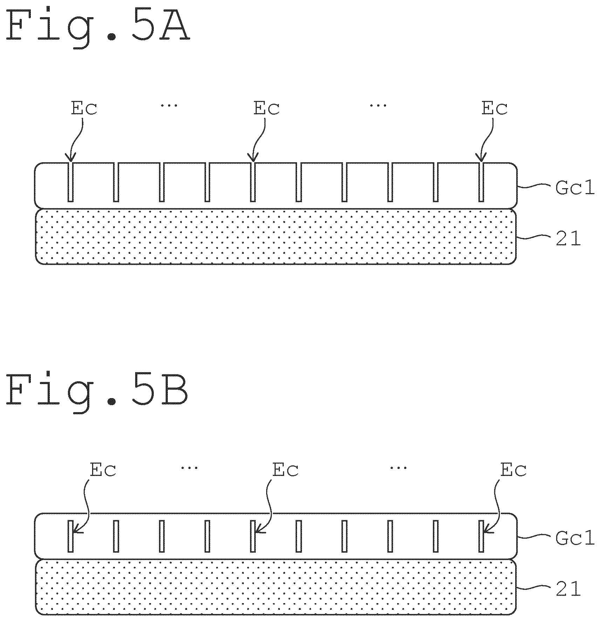

FIG. 5A is a conceptual view showing a vertical section taken along a line Za-Za shown in a lower left view of FIG. 3 and enlarged in a thickness direction. FIG. 5A shows a case where grooves are formed as the cutting sites Ec. These grooves can be formed by cutting the first joining target Gc1 to a depth just ahead of reaching a surface closer to the first holding sheet 21 (a surface held by the first holding sheet 21) using a blade, laser light, or plasma, for example.

Instead of the grooves, holes or internal defects may be formed as the cutting sites Ec. FIG. 5B shows a case where voids that are kinds of the internal defects are formed as the cutting sites Ec.

Such configurations of the cutting sites Ec keep the adjacent chip regions Rc in a state of being continuous with each other, making it unlikely that the chip regions Rc will be displaced during transport or joining of the first joining target Gc1.

### <Second Forming Step>

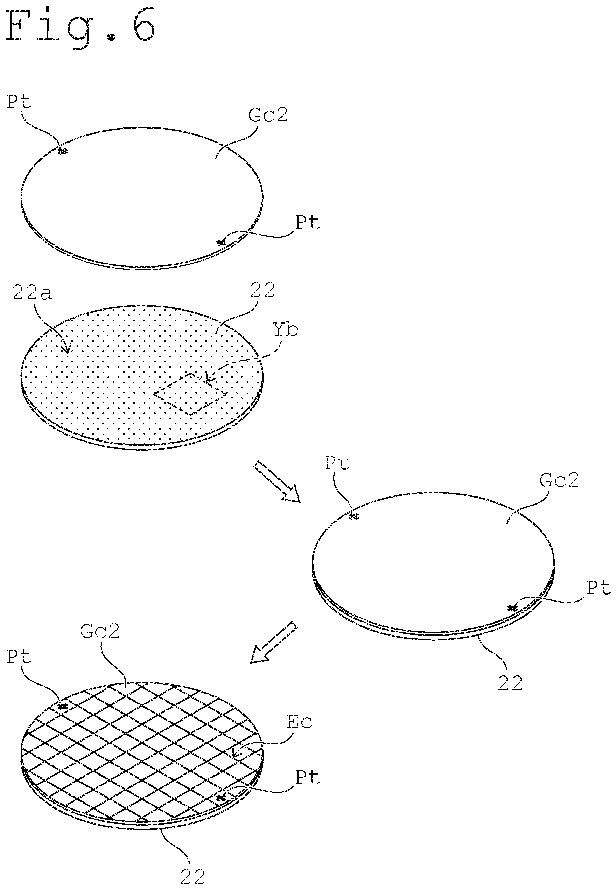

FIG. 6 is a conceptual view showing the second forming step. In the second forming step, the second joining target Gc2 thinned by the thinning step is held by a second holding sheet 22 (upper left view and right view of FIG. 6). Here, like the first holding sheet 21, the second holding sheet 22 is a sheet containing resin (such as polyolefin or silicone) or rubber (such as fluoride rubber) having at least an attractive force as a main component thereof, and can hold the second joining target Gc2 using the attractive force of the main component. In the present embodiment, the second holding sheet 22 further has a configuration as follows.

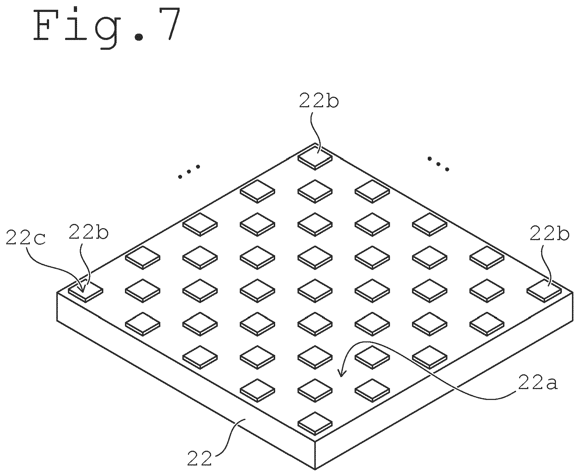

FIG. 7 is an enlarged perspective view about a part corresponding to a region Yb of the second holding sheet 22 shown in the upper left view of FIG. 6. As shown in this drawing, the second holding sheet 22 is provided with a plurality of projections 22b formed on a holding surface 22a for holding the second joining target Gc2. The projections 22b are made of a component same as the main component forming the second holding sheet 22 and are formed integrally with the second holding sheet 22. By bringing the second joining target Gc2 into surface-contact with the projections 22b, the second joining target Gc2 is held by the second holding sheet 22 using attractive forces of the projections 22b.

Meanwhile, when the second joining target Gc2 is held on the holding surface 22a, the second joining target Gc2 comes into surface-contact with the holding surface 22a only in parts where the projections 22b are provided. In the example of FIG. 7, the projections 22b are each formed in such a manner that a contact surface 22c thereof to come into contact with the second joining target Gc2 has a rectangular shape (including a square shape). As long as the contact surface 22c of the projection 22b allows the second joining target Gc2 to be held thereon, the shape thereof is not limited to a rectangular shape but may be changed to various shapes including a polygonal shape and a circular shape, as appropriate.

According to the second holding sheet 22 described above, it is possible to adjust an area of contact with the second joining target Gc2 by setting the number of the projections 22b or the area of the contact surface 22c. This eventually makes it possible to adjust the force of the second holding sheet 22 for holding the second joining target Gc2 (namely, a total sum of the attractive forces of the projections 22b). By adjusting the holding force of the second holding sheet 22, it becomes possible to maintain the holding force required for the first process and peel the second holding sheet 22 easily from the second joining target Gc2 after the first joining target Gc1 and the second joining target Gc2 are joined to (stacked on) each other in the joining step described later. More specifically, it is possible to adjust the holding force of the second holding sheet 22 at an appropriate degree so as not to break the joint part during peeling of the second holding sheet 22 from the second joining target Gc2. As a result, by holding the second joining target Gc2 using the described second holding sheet 22, it becomes possible to hold the second joining target Gc2 firmly and facilitate peeling or transfer without causing adverse effect (such as break) on the joint part and others when the peeling or transfer becomes necessary. Thus, even the thinned second joining target Gc2 can still be handled easily.

Furthermore, in the present embodiment, the respective holding surfaces 21a and 22a of the first holding sheet 21 and the second holding sheet 22 (see FIGS. 4 and 7) are provided with the projections 21b and 22b respectively in such a manner that an area of contact between the second holding sheet 22 and the second joining target Gc2 determined when the second joining target Gc2 is held by the second holding sheet 22 becomes smaller than an area of contact between the first holding sheet 21 and the first joining target Gc1 determined when the first joining target Gc1 is held by the first holding sheet 21. In this configuration, a difference in size is made between the contact areas to generate a difference in holding force. As a result, it becomes possible to generate a difference in peel strength (more specifically, the sheet having a smaller contact area is peeled more easily). Thus, when the second holding sheet 22 is to be peeled after the first joining target Gc1 and the second joining target Gc2 are joined to (stacked on) each other in the joining step described later, it is possible to peel only the second holding sheet 22 easily by taking advantage of the above difference in holding force (here, the difference in peel strength).

In the second forming step, after holding of the second joining target Gc2 using the second holding sheet 22, the cutting sites Ec to be used for singulating the chip regions Rc of the second joining target Gc2 individually are formed at the second joining target Gc2 in the holding state (lower left view of FIG. 6), like in the first forming step. More specifically, like the cutting sites Ec formed at the first joining target Gc1, at least any one of a groove, a hole, and an internal defect is formed as the cutting site Ec (see FIGS. 5A and 5B) to cause the second joining target Gc2 to fracture when the expandable and contractible sheet 23 is expanded in the expanding step (see FIG. 11) described later. Such configurations of the cutting sites Ec keep the adjacent chip regions Rc in a state of being continuous with each other, making it unlikely that the chip regions Rc will be displaced during transport or joining of the second joining target Gc2.

### <Joining Step>

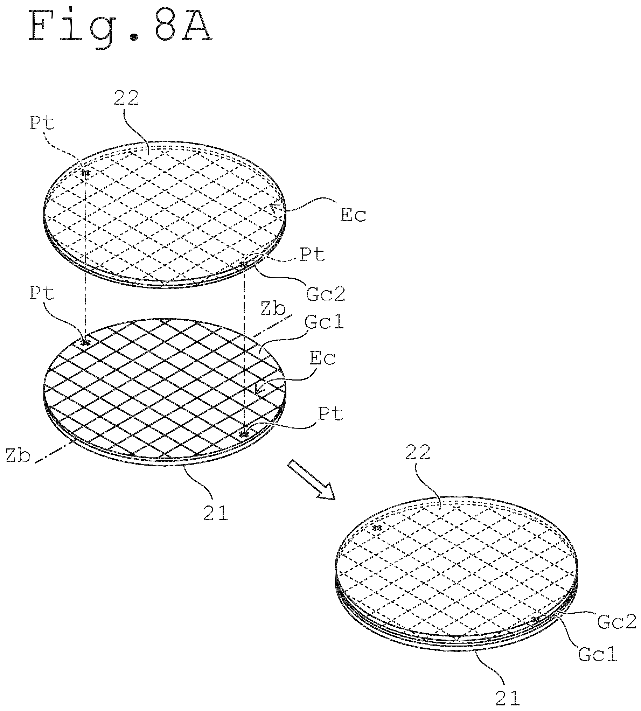

FIG. 8A is a conceptual view showing the joining step. After implementations of both the first forming step and the second forming step, in the joining step, the first joining target Gc1 and the second joining target Gc2 are joined in such a manner that the respective chip regions Rc thereof are stacked on each other in the predetermined positional relationship therebetween by moving the first holding sheet 21 and the second holding sheet 22 relative to each other.

In the present embodiment, the first joining target Gc1 and the second joining target Gc2 are joined to (stacked on) each other by moving the first holding sheet 21 and the second holding sheet 22 relative to each other in such a manner as to provide alignment between the respective positioning marks Pt formed at the first joining target Gc1 and the second joining target Gc2.

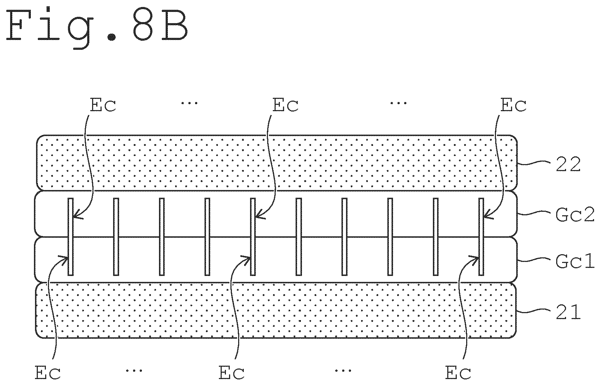

FIG. 8B is a conceptual view showing a vertical section taken along a line Yb-Yb shown in FIG. 8A and enlarged in a thickness direction. As shown in this drawing, the respective chip regions Rc are stacked on each other in the predetermined positional relationship therebetween by the joining step described above. Thus, the cutting site Ec formed at the first joining target Gc1 and the corresponding cutting site Ec formed at the second joining target Gc2 are aligned with each other in a plan view (in a view taken from above in the plane of the paper of FIG. 8B).

In this process, it is possible for all the chip regions Rc provided at the second joining target Gc2 to be collectively joined to (stacked on) all the chip regions Rc provided at the first joining target Gc1 through one joining. Thus, compared to a case where the chip regions Rc singulated individually from the second joining target Gc2 are stacked one by one on the first joining target Gc1, it is possible to simplify the processes of manufacturing the multilayer device 10 remarkably. More specifically, if the N chip regions Rc are provided at each of the first joining target Gc1 and the second joining target Gc2 and if the chip regions Rc singulated individually from the second joining target Gc2 are stacked one by one on the N chip regions Rc at the first joining target Gc1, stacking operation is required to be performed N times. On the other hand, as only one joining is required in the above processes of the present embodiment, it is possible to simplify the processes of manufacturing the multilayer device 10 remarkably.

### <Repetition from Thinning Step to Joining Step>

If the chips Mc are to be stacked in three or more layers on the base 11 in the multilayer device 10 to be manufactured like in the present embodiment (see FIG. 1), three or more chip parent materials Gc are required to be joined to each other. In this case, before moving to the transferring step described later, the thinning step, the second forming step, and the joining step are performed repeatedly in response to the number of the chip parent materials Gc to be joined. The repetition from the thinning step to the joining step will be described below in detail.

After the above-described joining step, the second holding sheet 22 is peeled from the second joining target Gc2. In the present embodiment, the holding force of the second holding sheet 22 is adjusted at a degree that does not cause break of the joint part between the first joining target Gc1 and the second joining target Gc2 during peeling of this sheet. Thus, practically no break resulting from peeling of the second holding sheet 22 occurs at the joint part. Furthermore, the respective holding surfaces 21a and 22a of the first holding sheet 21 and the second holding sheet 22 are provided with the projections 21b and 22b respectively in such a manner that an area of contact between the second holding sheet 22 and the second joining target Gc2 determined when the second joining target Gc2 is held by the second holding sheet 22 becomes smaller than an area of contact between the first holding sheet 21 and the first joining target Gc1 determined when the first joining target Gc1 is held by the first holding sheet 21. This generates a difference in holding force for holding the joining targets between the first holding sheet 21 and the second holding sheet 22 to eventually generate a difference in peel strength therebetween (more specifically, peeling is facilitated further with a smaller contact area). Thus, in the present embodiment, it is possible to peel only the second holding sheet 22 easily by taking advantage of the difference in holding force (here, the difference in peel strength).

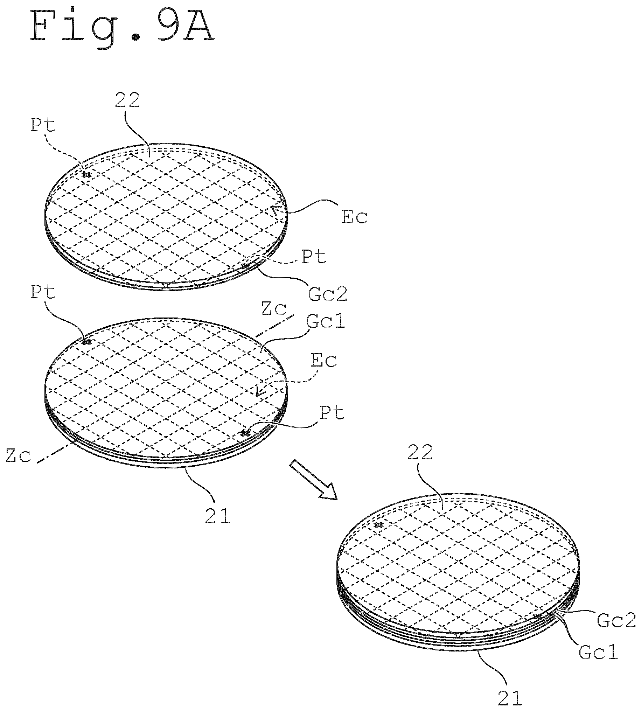

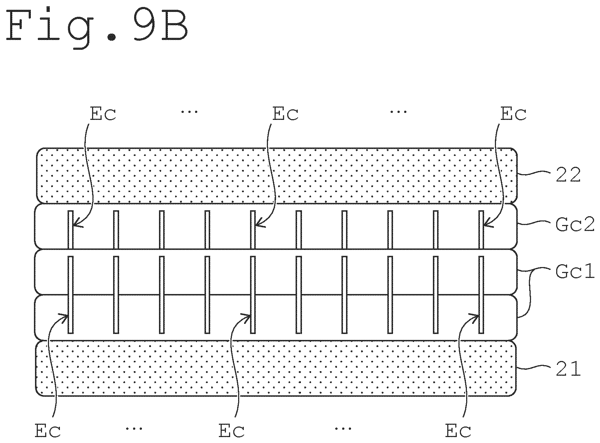

A different chip parent material Gc is thereafter joined further onto the second joining target Gc2. More specifically, using the first joining target Gc1 and the second joining target Gc2 joined to each other in the above-described joining step (see FIG. 8A) as a new first joining target Gc1 and using the different chip parent material Gc as a new second joining target Gc2, thinning of this second joining target Gc2, the second forming step (see FIG. 6), and the joining step (see FIGS. 9A and 9B) are performed further.

Then, peeling of the second holding sheet 22, thinning of the second joining target Gc2, the second forming step (see FIG. 6), and the joining step (see FIG. 9A) are performed repeatedly in response to the number of the chip parent materials Gc to be joined. In the present embodiment, the seven chip parent materials Gc are required to be joined. Thus, for joining the chip parent materials Gc from a third layer to a seventh layer further after performing the first-time joining step (see FIG. 8A), the above-described repetition is made five times.

According to these repetitive processes, even if the chip parent materials Gc (joining targets) as the second joining targets Gc2 are to be joined to (stacked on) the first joining target Gc1 several times, it is still possible for all the chip regions Rc provided at each of the chip parent materials Gc to be joined (stacked) collectively through one joining performed on each chip parent material Gc. More specifically, if the N chip regions Rc are provided at each of the first joining target Gc1 and a different chip parent material Gc (second joining target Gc2) and if the chip regions Rc singulated individually from the different chip parent material Gc (second joining target Gc2) are to be stacked one by one and M times three-dimensionally on the N chip regions Rc at the first joining target Gc1, stacking operation is required to be performed N × M times. By contrast, as performing joining M times is enough according to the above-described repetitive processes, it is possible to simplify the processes of manufacturing the multilayer device 10 remarkably.

### <Transferring Step>

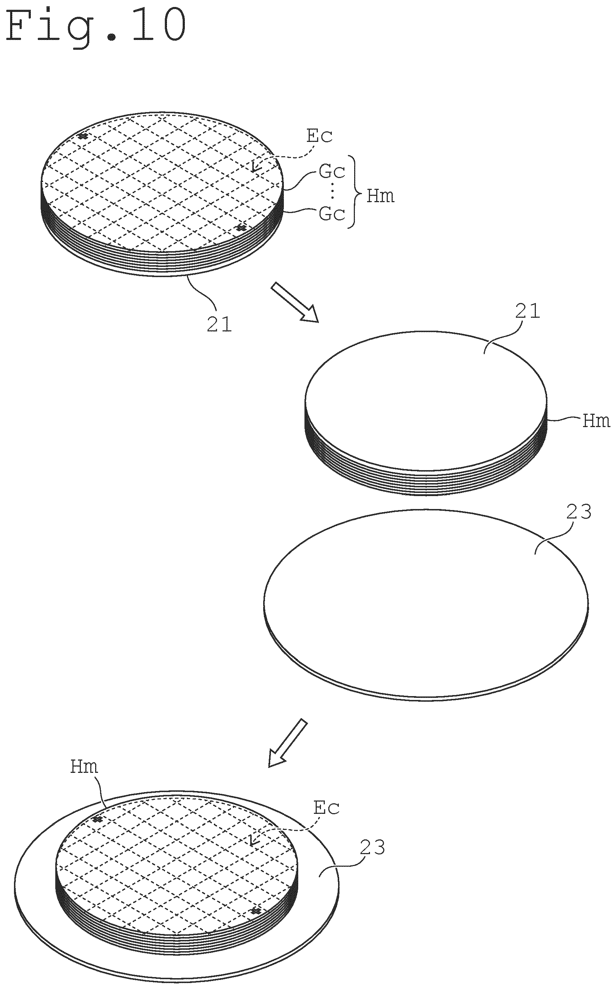

FIG. 10 is a conceptual view showing the transferring step. After an intended number of the chip parent materials Gc are joined to each other, in the transferring step, the second holding sheet 22 is peeled from a parent material stack Hm as a stack of the chip parent materials Gc and thereafter the parent material stack Hm is transferred to the expandable and contractible sheet 23 as a different holding sheet. In the transferring step, the first holding sheet 21 may be peeled from the parent material stack Hm and thereafter the parent material stack Hm may be transferred to the expandable and contractible sheet 23. Here, as described above, the holding forces of the first holding sheet 21 and the second holding sheet 22 (holding forces for holding the joining targets) are adjusted at degrees that do not cause break of the joint part (here, a joint part formed inside the parent material stack Hm) between the first joining target Gc1 and the second joining target Gc2 during peeling of the sheets. Thus, practically no break resulting from peeling of the first holding sheet 21 or the second holding sheet 22 (including peeling required for the transfer) occurs at the joint part.

Here, in order to allow pulling of the expandable and contractible sheet 23 while grasping an edge thereof, a sheet having a larger area than the chip parent material Gc is used as the expandable and contractible sheet 23. In order to provide this sheet with expanding and contracting properties, a sheet containing resin (such as polyolefin or silicone) or rubber (such as fluoride rubber) as a main component thereof having expanding and contracting properties in addition to an attractive force is available as the expandable and contractible sheet 23. In this case, like the first holding sheet 21 or the second holding sheet 22, the expandable and contractible sheet 23 may be provided with a plurality of projections formed on a surface on which the parent material stack Hm is to be transferred.

### <Expanding Step>

FIG. 11 is a conceptual view showing the expanding step. After the transferring step, the expandable and contractible sheet 23 is expanded to separate the adjacent chip regions Rc across the cutting site Ec from each other in the expanding step.

According to the above-described transferring step and expanding step, it is possible to cause a plurality of the joined chip parent materials Gc (joining targets) to fracture at the cutting sites Ec only through the simple process of expanding the expandable and contractible sheet 23 performed once. By doing so, the chip regions Rc provided at each of the joined chip parent materials Gc (joining targets) are singulated individually while the chip regions Rc in one group (in the present embodiment, one group includes the chip regions Rc in the seven layers) are maintained joined to (stacked on) each other, thereby allowing formation of the chip stack 12.

According to the first process described so far, regarding a technique of manufacturing the multilayer device 10, it is possible to simplify the manufacturing processes remarkably.

### [1-2-2] Second Process

In the second process, the multilayer device 10 illustrated in FIG. 1 is completed using a base parent material Gb provided with a plurality of regions (base regions Rb) to become the bases 11 and using the chip stacks 12 manufactured in the first process. While not particularly limited here, the base parent material Gb is a semiconductor wafer, for example.

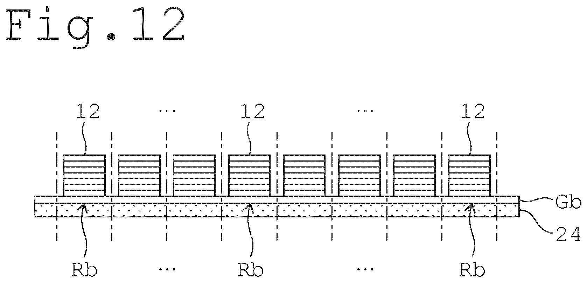

FIG. 12 is a conceptual view showing the second process. In the second process, the chip stacks 12 are joined one by one to the respective base regions Rb provided at the base parent material Gb in a predetermined positional relationship therebetween. In doing this, the base parent material Gb may be held by a holding sheet 24. A sheet similar to the first holding sheet 21 or the second holding sheet 22 is available as the holding sheet 24. After joining of the chip stacks 12 is completed in all the base regions Rb, the base parent material Gb is subjected to cutting (in the example of FIG. 12, the base parent material Gb is cut at positions indicated by alternate long and short dashed lines), thereby singulating the base regions Rb of the base parent material Gb individually. As a result, the multilayer device 10 (see FIG. 1) is completed.

### [2] Modifications

### [2-1] First Modification

In the first process of the above-described embodiment, instead of performing the transferring step, one of the first holding sheet 21 and the second holding sheet 22 may be used as an expandable and contractible sheet.

More specifically, at least one of the first holding sheet 21 and the second holding sheet 22 is composed of an expandable and contractible sheet having a larger area than the chip parent material Gc. In the above-described embodiment, if the first holding sheet 21 and the second holding sheet 22 contain resin (such as polyolefin or silicone) or rubber (such as fluoride rubber) as main components thereof having expanding and contracting properties in addition to an attractive force, these sheets are further given expanding and contracting properties in addition to attractive forces. In this case, the area of at least one of the sheets may be set larger than the area of the chip parent material Gc. Then, while a holding sheet that is one of the first holding sheet 21 and the second holding sheet 22 and configured as the expandable and contractible sheet is left unpeeled, the other holding sheet is peeled, and thereafter the holding sheet left unpeeled is expanded, thereby separating the adjacent chip regions Rc across the cutting site Ec from each other.

This configuration makes it possible to further simplify the first process.

### [2-2] Second Modification

In the above-described embodiment, the multilayer device 10 to be manufactured may be changed, as appropriate, to a device including the chips Mc of different sizes stacked on each other on the base 11. In this case, the chips Mc to be stacked can be formed into different sizes in the first process of the above-described embodiment by appropriately changing the width of the cutting site Ec to be formed at the chip parent material Gc in the first forming step or the second forming step.

FIG. 13 is a conceptual view showing an example about a stack of chip parent materials Gc obtained by a joining step performed first time in a second modification by means of a vertical section thereof enlarged in a thickness direction. In the exemplary case shown in FIG. 13, the widths of grooves (cutting sites Ec) formed at the second joining target Gc2 are set larger than the widths of grooves (cutting sites Ec) formed at the first joining target Gc1 in order for the sizes of the chips Mc obtained from the second joining target Gc2 to become smaller than the sizes of the chips Mc obtained from the first joining target Gc1.

### [2-3] Other Modifications

In the above-described embodiment, dicing tape may be used as the first holding sheet 21 or the second holding sheet 22, as appropriate.

In the above-described embodiment, the cutting site Ec may be changed to a site formed by cutting the chip parent material Gc completely, as appropriate, using a blade, laser light, or plasma, for example.

The above explanations of the embodiments and the modifications are nothing more than illustrative in any respect, nor should be thought of as restrictive. The scope of the present invention is indicated by claims rather than the above embodiments and modifications. Furthermore, it is intended that all changes that are equivalent to a claim in the sense and realm of the doctrine of equivalence be included within the scope of the present invention.

Some of the steps forming the method of manufacturing the multilayer device 10 may be extracted partially or each of these steps may be extracted individually as a subject of the invention from the above-described embodiments and modifications.

### Reference Signs List

10 Multilayer device
11 Base
12 Chip stack
21 First holding sheet
22 Second holding sheet
21a, 22a Holding surface
21b, 22b Projection
21c, 22c Contact surface
23 Expandable and contractible sheet
24 Holding sheet
Ec Cutting site
Gb Base parent material
Gc Chip parent material
Hm Parent material stack
Mc Chip
Pt Positioning mark
Rb Base region
Rc Chip region
Gc1 First joining target
Gc2 Second joining target

## Claims

1. A method of manufacturing a multilayer device performing:
a first forming step that forms a cutting site at a first joining target provided with a plurality of chip regions while the first joining target is held by a first holding sheet, the cutting site being used for singulating the chip regions of the first joining target individually;
a second forming step that forms a cutting site at a second joining target provided with a plurality of chip regions while the second joining target is held by a second holding sheet, the a cutting site being used for singulating the chip regions of the second joining target individually; and
a joining step that joins the first joining target and the second joining target in such a manner that the respective chip regions of the first joining target and the second joining target are stacked on each other in a predetermined positional relationship therebetween by moving the first holding sheet and the second holding sheet relative to each other.

2. The method of manufacturing the multilayer device according to claim 1, wherein
after the joining step, the second holding sheet is peeled from the second joining target and a different joining target provided with a plurality of chip regions is further joined to the second joining target,
the method further performing:
the second forming step and the joining step using the first joining target and the second joining target joined to each other in the joining step as a new first joining target and using the different joining target as a new second joining target.

3. The method of manufacturing the multilayer device according to claim 1 or 2, further performing:
a thinning step that thins the second joining target before the second forming step.

4. The method of manufacturing the multilayer device according to any one of claims 1 to 3, further performing:
a transferring step after the joining step, the transferring step peeling the first holding sheet or the second holding sheet and thereafter transferring the first joining target and the second joining target to an expandable and contractible sheet as a different holding sheet; and
an expanding step that expands the expandable and contractible sheet, thereby separates adjacent ones of the chip regions across the cutting site from each other.

5. The method of manufacturing the multilayer device according to any one of claims 1 to 3, wherein
at least one of the first holding sheet and the second holding sheet is configured as an expandable and contractible sheet,
the method further performing:
an expanding step after the joining step, while a holding sheet that is one of the first holding sheet and the second holding sheet and configured as the expandable and contractible sheet is left unpeeled, the expanding step peeling the other holding sheet, and thereafter the expanding step expanding the holding sheet left unpeeled, thereby separating adjacent ones of the chip regions across the cutting site from each other.

6. The method of manufacturing the multilayer device according to claim 4 or 5, wherein
in each of the first forming step and the second forming step, at least one of a groove, a hole, and an internal defect is formed as the cutting site to cause each of the first joining target and the second joining target to fracture when the expandable and contractible sheet is expanded in the expanding step.

7. The method of manufacturing the multilayer device according to any one of claims 1 to 6, wherein
each of the first holding sheet and the second holding sheet is a sheet containing resin or rubber having at least an attractive force as a main component thereof, and is provided with a plurality of projections formed on a holding surface for holding a corresponding one of the first joining target and the second joining target.

8. The method of manufacturing the multilayer device according to claim 7, wherein
the holding surfaces are provided with the respective projections in such a manner that an area of contact between the second holding sheet and the second joining target determined when the second joining target is held by the second holding sheet becomes smaller than an area of contact between the first holding sheet and the first joining target determined when the first joining target is held by the first holding sheet.
